(19) Europäisches Patentamt
European Patent Office
Office européen des brevets

(11) Publication number: **0 182 305**
**A2**

# (12) EUROPEAN PATENT APPLICATION

(21) Application number: **85114516.9**

(22) Date of filing: **15.11.85**

(51) Int. Cl.⁴: **G 11 C 17/00**

(30) Priority: **23.11.84 US 674213**

(43) Date of publication of application: **28.05.86 Bulletin 86/22**

(84) Designated Contracting States: **DE FR GB**

(71) Applicant: **International Business Machines Corporation, Old Orchard Road, Armonk, N.Y. 10504 (US)**

(72) Inventor: **Kimmel, Richard Daniel, 12 Sherrywood Rd, Wappingers Falls, N.Y. 12590 (US)**
Inventor: **Knepper, Ronald William, 352 Andrews Road, Lagrangeville, N.Y. 12540 (US)**
Inventor: **Levi, Richard, 1138 N.W. 83rd Ave, Coral Springs Florida 33065 (US)**

(74) Representative: **Rudack, Günter Otto, Dipl.-Ing., IBM Switzerland Zurich Patent Operations Säumerstrasse 4, CH-8803 Rüschlikon (CH)**

## (54) Read only memory.

(57) This read-only memory comprises a plurality of memory cells (1,1 . . . N, M) arranged in an array having N rows and M columns and consisting essentially of a single transistor,

N word lines (WL1 . . . WLN), each connected to the base of the transistors of said M memory cells in a discrete one of said N rows of memory cells;

M bit lines (BL1 . . . BLM), each associated with N memory cells (1,1 . . . N, M) in a discrete one of said M columns of memory cells, at least one of said M bit lines (BL1 . . . BLM) being connected to one or more of the emitters of the transistors of said M associated memory cells of said one, or more bit line (BL1 . . . BLM). The read-only memory further comprises a bit line bleeder current generator (T6 . . . T9, R2 . . . R4) connected to said M bit lines (BL1 . . . BLM) and maintaining a constant current in at least certain ones of said bit lines (BL1 . . . BLM),

a controllable read circuit (T1 . . . T5, R1) connected to said N word lines (WL1 . . . WLN) and M bit lines (BL1 . . . . BLM) for reading at least any predetermined one of said M x N array of memory cells,

a sense amplifier (T13 . . . T15, R5 . . . R8, SD1) for electrically manifesting the binary bit stored in the predetermined one of said M × N array of memory cells being read, and

an isolation circuit (T10 . . . T12) interconnecting said sense amplifier and said M × N array of memory cells (1,1 . . . N, m) and reducting the capacitive impedance load on said sense amplifier (T13 . . . T15, R5 . . . R8, SD1), whereby the read time of a read operation is materially reducted and the electrical manifestation is materially enhanced.

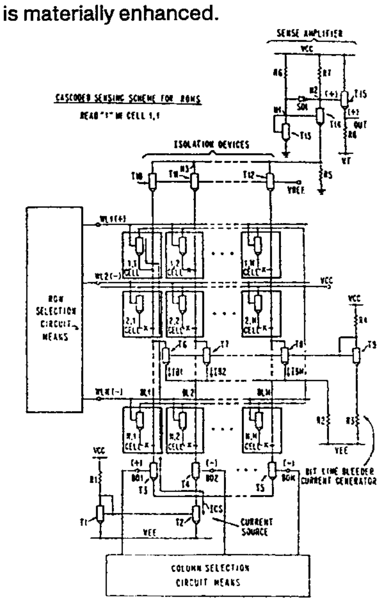


EP 0 182 305 A2

# READ ONLY MEMORY

The invention is directed to an improved read-only memory (ROM).

There are numerous circuits and structures known in the prior art as read-only memories. One such read-only memory may be generally described as follows:

The memory employs an array of storage cells having m columns and n rows. Each storage cell includes a transistor having a collector, base and emitter. The transistors in the m x n array have a common collector and are formed in a single isolation region. During manufacture of the array each emitter of a transistor is either connected, or not, to its appropriate emitter rail according to a particular desired binary bit pattern. Information is then determined during the read out of the storage device by sensing whether or not current flows through a particular device at the intersection of two selected base and emitter rails.

The following patents and publications are set-forth as representative of the prior art:

US-A-3,617,772 discloses a sense amplifier/bit driver circuit for a monolithic memory storage cell using a double ended bit drive and sensing scheme. Each of the bit lines serving this storage cell is fed to the emitter of a separate transistor of the sense/drive circuit. The collectors of both these transistors are connected to

opposite ends of a differential sense amplifier while the bases of the transistors are connected to a diode logic circuit which controls the potential at the base. By changing the potential at the bases of the transistors, conduction through the transistors may be varied in concert or individually for reading and writing of information in the storage cells and for turning the transistors off while the storage cell is not being addressed.

US-A-3,735,358 relates to a read only memory comprising a plurality of semiconductor device cells arranged in rows and columns. Spaced conductive lines extending in a Y direction are connected to a first cell terminal. A plurality of second cell terminals defining a row or column are selectively interconnected to one or the other of a pair of adjacent X lines. The semiconductor device cells interconnected between the adjacent X line pair are responsive to digital input signals applied on the plurality of Y lines to generate distinct logical signals on the pair of adjacent X lines.

US-A-3,745,539 teaches a semiconductor circuit for reading an FET capacitor store dynamic memory cell and for regenerating the charge (if any) in said capacitor, whereby non-destructive read-out is achieved. The memory cell includes an FET switch for selectively connecting the storage capacitor to a memory array bit-sense line through either one of a pair of oppositely connected bipolar transistors for reading and writing, respectively. The bit-sense line is connected to the input terminal of a latching regenerative feedback amplifier such as a silicon controlled rectifier. The potential level at said

input terminal rises to a relatively higher level by regenerative feedback action in response to a relatively lower bit-sensing voltage which initiates the latching action.

US-A-4,031,522 relates to a high impedance regenerative differential sense amplifier for use with an integrated circuit memory array of single transistor cells. Each of the sense amplifiers is formed of a cross coupled latch connected to the respective columns by source followers and leads from the latch drive write back gates coupled to the respective columns so as to restore a "zero" level of a cell and also leave a precharged "one" level with the cell by charging the appropriate column. The respective columns are initially precharged and balanced and then driven by negative going signals.

US-A-4,031,524 concerns a read-only memory and sense amplifier system for sensing whether a selected memory cell of a memory bank includes a high-impedance memory device, or a low-impedance device, and for generating a binary output signal representing stored data in response to the sensed difference. The cells are programmed with a pattern of high and low-impedance devices, such as inoperative and operative field-effect transistors in accordance with stored data. The memory bank, including the impedance of the selected cell, is connected to a first input node of the amplifier, and has either a first or "ON" bank impedance between the first node and a reference node if the selected cell is in the low-impedance state or a second or "OFF" bank impedance if the selected cell is in the high-impedance state. A reference

impedance is connected between the other amplifier node and the reference node, and has a value between the ON bank impedance and the OFF bank impedance. The amplifier includes circuitry for sensing a difference in impedance connected to the two nodes, and for generating the binary output signal in response to the sensed difference, representing the data stored in the selected memory cell.

In the read-only memory module disclosed in US-A-4,037,218 storage elements are arranged between intersecting row lines and column lines, each column line being connected to a fixed auxiliary voltage by way of an auxiliary resistor and the value of the auxiliary voltage being more negative than the voltage on the row line selected during a read operation, and the value of the auxiliary resistors being sufficiently large that the current on a selected column line flowing from the auxiliary voltage source by way of the auxiliary resistor into the selected column line is small vis-a-vis the read current flowing in the column line.

In US-A-4,048,626 a read-only memory is disclosed wherein the bits of a given word are separately stored in a number of individual storage arrays. The individual storage arrays each contain a plurality of addressable bit storage locations. These bit storage locations are first accessed and thereafter sensed in response to a given address. The accessing and sensing is implemented by current mode logic in a manner which effectively develops and thereafter utilizes various current paths.

US-A-4,070,654 teaches a bipolar read-only memory comprising a matrix circuit having selection input lines, digit output lines and Schottky barrier diodes connected

between the selection input lines and the digit input lines according to information contained in the memory. A selection input circuit of an $I^2L$ construction is electrically associated with the selection input lines, and a digit output circuit of an $I^2L$ construction is electrically associated with the digit output lines.

US-A-4,122,545 relates to a memory circuit including an array of inversion controlled switches arranged in an arbitrary number of rows and columns. Each inversion controlled switch is provided with emitter, base and collector terminals, and is characterized by first and second impedance states between its emitter and collector terminals. The memory circuit further includes voltage means coupled with the inversion controlled switches of the array for applying a selectively controllable voltage across the emitter and collector terminals of these switches in selected ones of the rows; a plurality of rectifier means each coupled with the base terminal of a respective inversion controlled switch; current means coupled with the rectifier means for applying a current level to the base terminals of the inversion controlled switches in selected ones of the columns through the rectifier means; and data sensing means coupled with the inversion controlled switches in individual ones of the columns for sensing the impedance state of a selected one of the switches in a respective one of the columns.

US-A-4,215,282 discloses a sense amplifier and sensing scheme for sensing the normal or blown condition of fuses in a programmable read only memory (PROM) or similar device. A sensing circuit is provided with a threshold level separating high and low input levels

indicative of the fuse condition. The sensing circuit has one circuit branch with a first current mirror with a temperature characteristic which provides a threshold level which is slightly divergent with reference to a low level input. Another circuit branch clamps the high input level to the slightly divergent threshold level and uses a second current mirror with a temperature characteristic which provides a high level slightly more divergent than the threshold level. By selecting mirror currents proportionally, high level and threshold level temperature characteristic divergence can be proportionally controlled in selected amounts with respect to the low level.

IBM Technical Disclosure Bulletin Vol. 13, No. 9, pp. 2770/71 shows a high-speed monolithic read-only storage circuit comprising a plurality of storage arrays of m by n bits. Each array comprises m by n transistors each having a common collector. During manufacture of the array each emitter of every transistor is either connected or not to its appropriate emitter rail, according to a particular desired bit pattern. Information is then determined during the read out of the storage device by sensing whether or not current flows through a particular device at the intersection of two selected base and emitter rails. To accomplish the bit sensing, an additional array of transistors is produced in a special isolation region. The common collector point for the array is connected to a reference point, and a reference voltage is connected to the common base node of the transistors. Bit sensing then takes place at the common collector node of the transistors so that the addressed

bit is sensed by an uplevel voltage to turn on a transistor to switch the common current sink into the desired emitter rail.

The primary object of the invention is to provide an improved read-only memory.

A further object of the invention is an improved high-speed read-only memory.

A still further object of the invention is to provide a read-only memory including isolation circuit means and improved sensing means to enhance the speed at which the memory may be read.

The read-only memory in accordance with the invention utilizes a two-level cascoded current steering approach feeding a two-level common base isolation and sense amplifier network. The isolation network allows formation of a multi-way collector dot without deleterious effect upon the high-speed current sensing operation. Single transistor cells with a common subcollector bed and common base rails as word lines make up the highly dense, high-speed array. The current source is provided by a current mirror circuit. The common-base, low-impedance sense amplifier converts the sense current signal into a voltage swing which is then fed to the off-chip driver circuit via an emitter-follower predriver stage.

Other objects, advantages and features of the invention will be apparent from the following detailed description of specific examples and embodiment, when

taken in conjunction with the appended drawings of the preferred embodiment. In the drawings:

Fig. 1 discloses a read only memory, in accordance with the invention, wherein a binary "1" is stored in cell 1,1 of the m x n array of memory cells;

Fig. 2 discloses a read only memory, in accordance with the invention, wherein a binary "0" is stored in cell 1,1 of the m x n array of memory cells.

The cascoded sensing scheme for ROMS, in accordance with the invention provides high-speed sensing capability in a highly dense bipolar read-only memory chip (ROM).

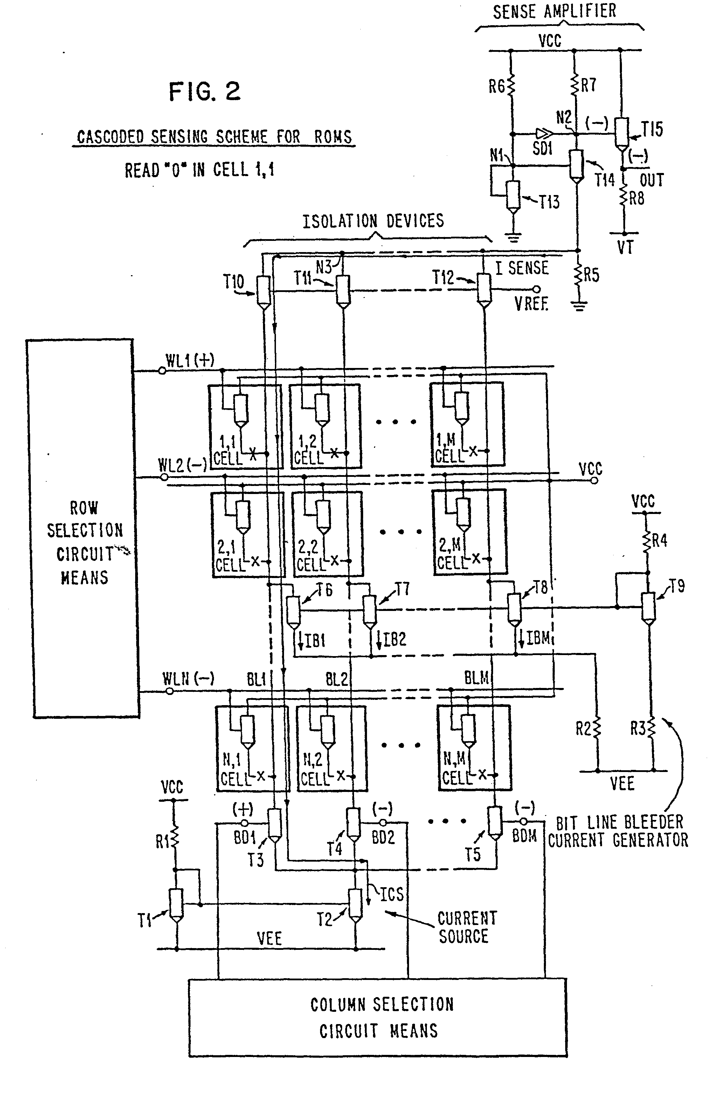

Figures 1 and 2 show the circuit schematic of the present invention under conditions of reading a "1" and reading a "Ø", respectively. In Figure 1 cell 1,1 has been selected by raising word line WL1 to an up-level while holding word lines WL2...WLN at their down-level voltage. At the same time bit select transistor T3 has been turned on with a positive-going signal at node BD1 (while transistors T4...T5 remain off due to down-levels at their respective base terminals) causing current $I_{CS}$ to be steered through TZ3, into bit line BL1, and through cell 1,1. $I_{CS}$ is generated at the bottom of the cascode tree by a current mirror comprises of devices T1 and T2 with resistor R1. Since cell 1,1, current $I_{CS}$ is steered through cell 1,1 and into the common array subcollector bed connected to the $V_{CC}$ supply. (The up-level of word line WL1 is, of course, higher in potential than the reference voltage at the base of the isolation transistors T10, T11, ...T12.)

Since current $I_{CS}$ has been steered through cell 1,1, no sense current flows through isolation transistor T10 and through the sense amplifier transistor T14, thus causing the sense amplifier node N2 to charge to an up-level via resistor R7. Therefore, the output is at an up-level, as indicated in Figure 1.

Reference is now made to Figure 2 for the description of a read "Ø" operation. In this case cell 1,1 is selected, as in Figure 1, causing the select current $I_{CS}$ to be steered through bit select transistor T3 and onto bit line BL1. However, since cell 1,1 contains a "Ø", no physical connection from bit line BL1 to the emitter of cell 1,1 exists, and thus, current $I_{CS}$ is steered through isolation transistor T10 and into node N3. (Node N3 is comprised of a fairly large capacitance due to the collector dot of transistor T10...T12.) The voltage on node N3 drops slightly, turning on T14 and causing select current $I_{CS}$ to flow through T14 and resistor R7 to the most positive supply $V_{CC}$. (Actually, positive current flows in the opposite direction from that described, i.e. from $V_{CC}$ to $V_{EE}$.) The voltage on node N2 therefore, drops to a down-level and causes the output to be pulled to a down-level by resistor R8.

The sensing of a "1" or a "Ø" is a high-speed operation, particularly since devices T10...T12 isolate the high capacitance of the collector dot on node N3 from the sense node N2, thus allowing R7 to charge node N2 rapidly (for a "1") and $I_{CS}$ to discharge N2 rapidly via T14 (for a "Ø"). Resistor R6 and transistor T13 act as a low-impedance voltage source, maintaining node N1 at one $V_{BE}$ above ground. Resistor R5 bleeds current through T14

at all times, thus maintaining T14 in its linear conductive state, so as to provide a high-speed sensing operation. Schottky diode SD1 prevents T14 from saturating when sensing a "Ø".

Transistors T6, T7...T8, and T9 along with resistors R2, R3, and R4 comprise a bit line bleeder current generator for the purpose of bleeding a small current from each bit line at all times. These small bleeder currents keep each unselected bit line from floating to a more positive potential, which would then impact (lengthen) the access time upon selection of such a bit line. The bleeder currents maintain each unselected bit line at a potential of one $V_{BE}$ below either the isolation network reference voltage (V REF) or the selected word line voltage, depending upon whether each cell on the selected word line contains a "Ø" or a "1", respectively.

The layout of the array is constructed with P+ diffused base rails in parallel with and shorted periodically to first meal wires as the word lines. Second metal wires form the bit lines with the personalization accomplished by the presence or absence of a connecting via between the first level emitter metal and the second level metal bit line for any given cell. The collectors of each array cell form one larged subcollector bed. The layout allows both high density and high performance due to the single device compact cells and the metal lines on both first and second levels, thus eliminating any series resistance delay penalties on the word or bit lines.

CLAIMS

1. Read-only memory including a plurality of memory cells arranged in an array having N rows and M columns, each of said memory cells storing a binary bit ("1" or "0") of data, each of said memory cells consisting essentially of a transistor having a collector, base and emitter;

N word lines each connected to the bases of said M transistors of said M memory cells in a discrete one of said N rows of memory cells;

M bit lines each being associated with N memory cells in a discrete one of said M columns of memory cells, at least one of said M bit lines being connected to one or more of the emitters of the transistors of said N associated memory cells of said one, or more bit lines, characterized by

a bit line bleeder current generator (R2...R4, T6...T9) connected to said M bit lines (BL1...BLM) and maintaining a constant current in at least certain ones of said bit lines (BL1...BLM),

controllable read means (T1...T5, R1) connected to said N word lines (WL1...WLN) and M bit lines (BL1...BLM) for reading at least any predetermined one of said M x N array of memory cells (1,1...N, M),

a sense amplifier (R5...R8, T13...T15, SD1) for electrically manifesting the binary bit stored in the predetermined one of said M x N array of memory cells (1,1...N, M) being read and

an isolation circuit (T10...T12) interconnecting said sense amplifier (R5...R8, T13...T15, SD1) and said M x N memory cells, (1,1...N, M) and reducing the capacitive impedance load on said sense amplifier (R5...R8, T13...T15, SD1).

2. Read-only memory in accordance with claim 1, characterized in that said isolation circuit includes M transistors (T10...T12), the M collectors of said M transistors (T10...T12) being connected in common to said sense amplifier (R5...R8, T13...T15, SD1), the M bases of said M transistors (T10...T12) being connected in common to a source of reference potential (VREF), and each of the M emitters of said transistors (T10...T12) being connected to a discrete one of said M bit lines (BL1...BLM).

3. Read-only memory in accordance with claim 1, characterized in that said controllable read circuit (T1...T5, R1) includes a first group of M transistors (T3...T5) having their collectors connected to a discrete one of said M bit lines (BL1...BLM), and a second group of transistors (T1, T2) of which a first transistor (T1) has its collector and base connected in common via a first resistor (R1) to a first source of potential (VCC), the base of a second transistor (T2) of the second group being connected to the base of said first transistor (T1), the collector of said second transistor (T2) being connected in common to said M emitters of said first group of M transistors (T3...T5) and that the emitters of said first and second transistors (T1, T2) are connected to a second source of potential (VEE).

4. Read-only memory in accordance with claim 1, characterized in that said bit line bleeder current generator (r2...R4, T6...T9) includes a group of M transistors (T6...T8), each having its collector respectively connected to a discrete one of said M bit lines (BL1...BLM), the emitters of said group of M transistors

(T6...T8) being connected in common via a first resistor (R2) to a second source of potential (VEE), and

a separate transistor (T9) having its emitter connected via a second resistor (R3) to said second source of potential (VEE), said separate transistor (T9) having its base and collector connected in common with the bases of said group of M transistors (T6...T8) and by a third resistor (R4) to said first source of potential (VCC).

5. Read-only memory in accordance with claim 1, characterized in that said sense amplifier (R5...R8, T13...T15, SD1) has an input connected to said isolation circuit (T10...T12) and an output for electrically manifesting the binary bit stored in the predetermined one of said N x M array of memory cells (1,1...N, M) being read, said sense amplifier comprising

a first resistor (R6) and a diode-connected first transistor (T13) serially connected between a first potential source (VCC) and a second potential source (Ground),

a second transistor (T14) having its base connected to the collector of said diode-connected first transistor (T13), the collector of said second transistor (T14) being connected via a second resistor (R7) to said first potential source (VCC), the emitter of said second transistor (T14) being connected via a third resistor (R5) to said second potential source (Ground), and said input of said sense amplifier being connected to the emitter of said second transistor (T14), and

a third transistor (T15) having its base connected to the collector of said second transistor (T14), the collector of said third transistor (T15) being connected

to said first potential source (VCC), the emitter of said third transistor (T15) being connected via a fourth resistor (R8) to a third potential source (VT), and said output of said sense amplifier being connected to the emitter of said third transistor (T15).

FIG. 1

CASCODED SENSING SCHEME FOR ROMS

READ "1" IN CELL 1,1

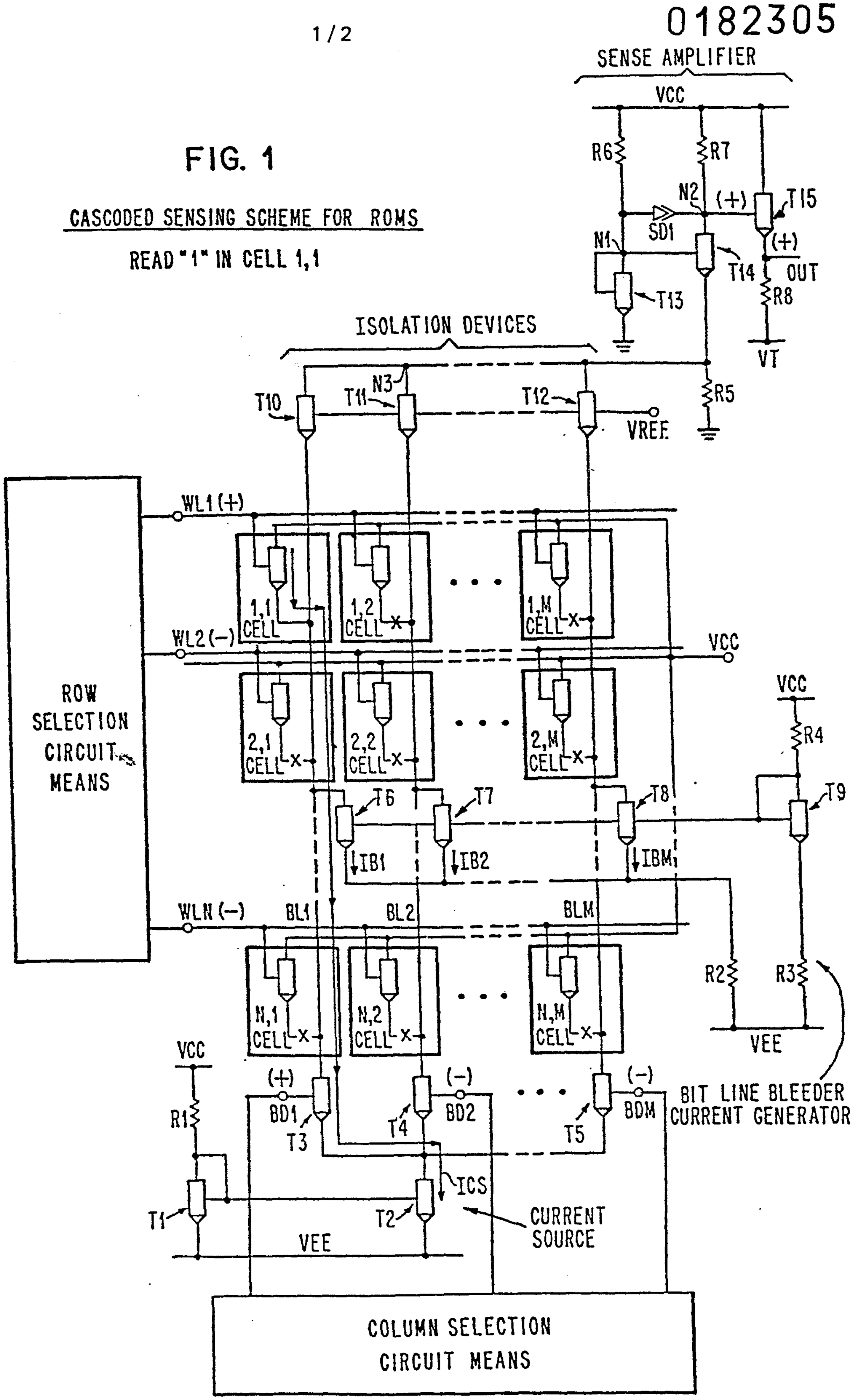

FIG. 2

CASCODED SENSING SCHEME FOR ROMS

READ "0" IN CELL 1,1